# EUROPEAN PATENT APPLICATION

(11) **EP 4 800 524 A1**
(43) Date of publication of application: **02.09.2026**
(21) Application number: 26160409.4
(22) Date of filing: 24.02.2026
(51) Int. Cl.: G05F 1/569, G05F 1/575, G05F 1/595, G05F 1/618, G05F 1/62, H02M 3/158

(54) **OPEN-CIRCUIT/PIN-LIFT DETECTOR**

(30) Priority: 27.02.2025 US 202519065848
(71) Applicant: NXP USA, Inc., Austin, TX 78735 (US)
(72) Inventor: Mansri, Mohammed, 5656AG Eindhoven (NL)
(74) Representative: Krott, Michel

(57) **Abstract**

One example discloses a power regulator, including: a power output node configured to be coupled to a high-side of a load; a load ground node configured to be coupled to a low-side of the load; a negative feedback node (Fbm) configured to form a negative feedback path when coupled to the low-side of the load; a controller configured to regulate voltages at the power output node and the load ground node in response to a voltage on the negative feedback path; a current source configured to inject a current at the negative feedback node (Fbm); and a detector circuit configured to monitor a voltage (VFbm) at the negative feedback node (Fbm); wherein the detector circuit is configured to switch the negative feedback node (Fbm) from the load ground node to an internal ground node, if the voltage (VFbm) exceeds a predetermined threshold voltage.

## Description

The present specification relates to systems, methods, apparatuses, devices, articles of manufacture and instructions for open-circuit/pin-lift detection.

### SUMMARY

According to an example embodiment, a power regulator, comprising: a power output node configured to be coupled to a high-side of a load; a load ground node configured to be coupled to a low-side of the load; a negative feedback node (Fbm) configured to form a negative feedback path when coupled to the low-side of the load; a controller configured to regulate voltages at the power output node and the load ground node in response to a voltage on the negative feedback path; a current source configured to inject a current at the negative feedback node (Fbm); and a detector circuit configured to monitor a voltage (VFbm) at the negative feedback node (Fbm); wherein the detector circuit is configured to switch the negative feedback node (Fbm) from the load ground node to an internal ground node, if the voltage (VFbm) exceeds a predetermined threshold voltage.

In another example embodiment, the load ground node is a remote sensing external ground.

In another example embodiment, the internal ground node is a reference potential within the power regulator that is not directly connected to the load ground node.

In another example embodiment, the detector circuit is configured to disable or shut down at least one of the power regulator or the load, if the voltage (VFbm) exceeds the predetermined threshold voltage.

In another example embodiment, further comprising a switch (S1) coupled between the negative feedback node (Fbm) and the internal ground node; wherein the detector circuit is configured to close the switch (S1) if the voltage (VFbm) exceeds the predetermined threshold voltage;

In another example embodiment, when the switch (S1) is closed, the negative feedback node (Fbm) is directly and galvanically coupled to the internal ground node.

In another example embodiment, the detector circuit is configured to switch the negative feedback node (Fbm) from the internal ground node back to the load ground node, if the voltage (VFbm) is equal to or less than the predetermined threshold voltage.

In another example embodiment, the power regulator is configured to be close-loop coupled to the load.

In another example embodiment, the detector circuit is configured to set a flag if the voltage (VFbm) exceeds the predetermined threshold voltage.

In another example embodiment, the power regulator is configured to disable either the power regulator or the load in response to the flag.

In another example embodiment, the power regulator is at least one of: a Buck converter, a pulse-width modulator circuit, a low drop out (LDO) regulator, or a linear regulator.

In another example embodiment, the detector circuit is configured to repeatedly check if the voltage (VFbm) exceeds the predetermined threshold voltage.

In another example embodiment, the negative feedback node (Fbm) is at least one of: an output node of a chip package in which the power regulator is embedded, or a wire bond between an integrated circuit die and a lead-frame within a chip package.

In another example embodiment, the detector circuit is coupled to control the current injected by the current source at the negative feedback node (Fbm).

In another example embodiment, the detector circuit is configured to cause the current source to inject the current at multiple intervals after the power regulator starts operating and before the power regulator stops operating.

In another example embodiment, the detector circuit is configured to adjust an amplitude or duration of the current injected by the first current source based on a load current drawn by the load at the power output node and the load ground node.

In another example embodiment, further comprising a positive feedback node (Fbp) configured to be coupled to the high-side of the load; wherein the current source is a first current source and the current is a first current; a second current source configured to inject a second current at the positive feedback node (Fbp); wherein a positive feedback path is formed when the positive feedback node (Fbp) is coupled to the high-side of the load; wherein the detector circuit is configured to monitor a voltage (VFbp) at the positive feedback node (Fbp); and wherein the detector circuit is configured to disable or shut down at least one of the power regulator or the load, if the voltage (VFbp) exceeds a predetermined threshold voltage.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents an example of a first power regulator circuit.
Figure 2 represents an example of a second power regulator circuit.
Figure 3 represents an example of the second example power regulator circuit with an open-circuit (pin-lift) event.
Figure 4 represents an example timing diagram of the second example power regulator circuit in operation.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

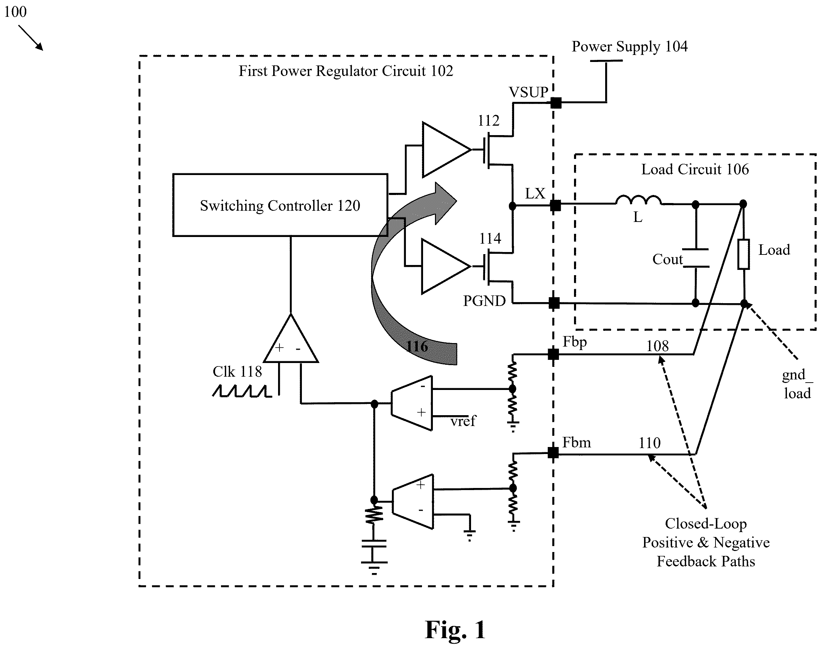

Figure 1 represents an example 100 of a first power regulator circuit 102. The example 100 further includes a power supply 104, a load circuit 106, a positive feedback path 108 (e.g. Fbp, high-side of load), a negative feedback path 110 (e.g. Fbm, low-side of load).

The first power regulator circuit 102 includes a high-side switch 112, a low-side switch 114, a set of circuit elements forming a closed-loop regulation path 116, a positive feedback pin (Fbp), a negative feedback pin (Fbm), a power supply pin (PSUP), a power output pin (LX), and a power ground pin (PGND).

The set of circuit elements forming the closed-loop regulation path 116 are configured to receive a clock signal 118 from a timing circuit (not shown), and include a switching controller 120 for controlling the high-side switch 112 and the low-side switch 114.

The first power regulator circuit 102 in various example embodiments can be a Buck converter, a pulse-width modulator circuit, a linear regulator, or any power regulator configured to be coupled to a load as a closed loop circuit.

During operation, closed-loop circuits such as in example 100 can suffer from an open-circuit (e.g. pin-lift) condition in their feedback paths 108, 110 to the positive feedback pin (Fbp) and/or the negative feedback pin (Fbm) resulting in a loss of regulation and potential damage to the power supply 104, the first power regulator circuit 102 (e.g. DC-DC voltage regulator), and/or the load circuit 106.

Circuits that detect such open-circuit/pin-lift conditions are needed. Such circuits should minimize or prevent damage to a power supply, voltage regulator, and/or load (e.g. prevent output voltage overshoots that could damage the load).

With such open-circuit/pin-lift detection circuits, the power supply, voltage regulator, and/or load can be safely shut-down, as well as placing various other coupled systems into their safe-modes.

Now discussed are various example embodiments of an open-circuit/pin-lift detector configured to detect various pin-lift conditions in a monitored circuit. The open-circuit/pin-lift detector may be embedded in power regulation circuits, such as voltage regulators, LDO (low drop out) regulators, PMICs (Power Management Integrated Circuits), etc., as well as other circuits that are configured to be coupled to a load as a closed loop circuit.

"Pin-lift" is herein defined as anything that would interfere with continuity (e.g. broken wire, broken wire-bond, broken integrated circuit trace, solder break, un-plugging a device, etc.), either internal to an integrated circuit, internal to a chip package, on a printed circuit board (PCB), or within an electronic system.

The example embodiments of the open-circuit/pin-lift detector can be used in normal mode or low power mode without affecting the efficiency of the system and without additional pins. The open-circuit/pin-lift detector can be added to existing pulse-width modulation blocks in a DC-DC regulator or linear regulator or any close loop system and do not require any changes to the functional or parametric requirements of the voltage regulators to work.

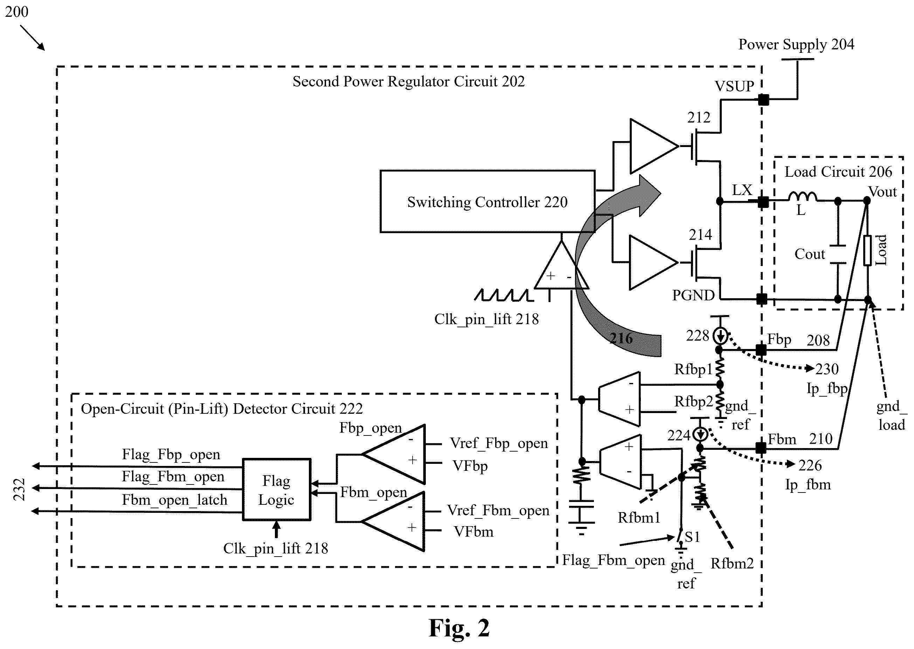

Figure 2 represents an example 200 of a second power regulator circuit 202. The example 200 further includes a power supply 204, a load circuit 206, a positive feedback path 208 (e.g. Fbp, high-side of load), a negative feedback path 210 (e.g. Fbm, low-side of load). A power ground (PGND) is also shown and connects to a reference potential.

The second power regulator circuit 202 includes a high-side switch 212, a low-side switch 214, a set of circuit elements forming a closed-loop regulation path 216, a positive feedback pin (Fbp), a negative feedback pin (Fbm), a power supply pin (PSUP), a power output pin (LX), and a power ground pin (PGND).

The set of circuit elements forming the closed-loop regulation path 216 are configured to receive a clock (Clk) signal 218 from a timing circuit (not shown), and include a switching controller 220 for controlling the high-side switch 212 and the low-side switch 214, an open-circuit (pin-lift) detector circuit 222, a first current source 224 configured to generate a first current (Ip_fbm) 226, a second current source 228 configured to generate a second current (Ip_fbp) 228, and a switch (S1). The switch (S1) is configured to be connected to a reference potential (e.g. an internal ground within the second power regulator circuit 202).

The second power regulator circuit 202 in various example embodiments can be a Buck converter, a pulse-width modulator circuit, a linear regulator, or any power regulator configured to be coupled to a load as a closed loop circuit.

The open-circuit (pin-lift) detector circuit 222 includes an Fbp_open comparator, a Fbm_open comparator, and a set of flag logic. The set of flag logic receives a set of input signals, including the clock signal (Clk_pin_lift) 218 (or a derivative thereof), an Fbp_open signal, and a Fbm_open signal. The set of flag logic is configured to generate as set of output signals 232 (e.g. Flag_Fbp_open, Flag_Fbm_open, and Fbp or Fbm_open_latch) based on the input signals.

The first current source 224 injects a first current (Ip_fbm) 226 into the negative feedback pin (Fbm) resulting in a voltage VFbm at the negative feedback pin (Fbm). The second current source 228 injects a second current (Ip_fbp) 230 into the positive feedback pin (Fbp) resulting in a voltage VFbp at the positive feedback pin (Fbp).

The open-circuit (pin-lift) detector circuit 222 compares the voltage VFbm with Vref_Fbm_open and generates the Fbm_open signal if VFbm exceeds Vref_Fbm_open. VFbm will exceed Vref_Fbm_open only if an open-circuit (pin-lift) event has occurred at the negative feedback pin (Fbm).

Similarly, the open-circuit (pin-lift) detector circuit 222 compares the voltage VFbp with Vref_Fbp_open and generates the Fbp_open signal if VFbp exceeds Vref_Fbp_open. VFbp will exceed Vref_Fbp_open only if an open-circuit (pin-lift) event has occurred at the positive feedback pin (Fbp).

If there is not an open-circuit (e.g. pin-lift) at the negative feedback pin (Fbm) then the first current (Ip_fbm) 226 passes to the load ground (gnd_load) which is also coupled to an external ground and the voltage (VFbm) at the negative feedback pin (Fbm) is set by the external ground. Since the first current (Ip_fbm) 226 passes to the load ground (gnd_load), VFbm does not exceed Vref_Fbm_open and thus the Fbm_open signal is not generated.

Since the Fbm_open signal is not generated, the flag logic in the open-circuit (pin-lift) detector circuit 222 does not set the Flag_Fbm_open flag.

Similarly, if there is not an open-circuit (e.g. pin-lift) at the positive feedback pin (Fbp) then the second current (Ip_fbp) 230 passes to the load at the output pin (Fbp ) and the voltage (VFbp) at the positive feedback pin (Fbp) is equal to Vout. Since the second current (Ip_fbp) 230 passes to the load at the output pin (Fbp), VFbp does not exceed Vref_Fbp_open and thus the Fbp_open signal is not generated.

Since the Fbp_open signal is not generated, the flag logic in the open-circuit (pin-lift) detector circuit 222 does not set the Flag_Fbp_open flag.

Since neither the Flag_Fbm_open nor the Flag_Fbp_open flags set, the second power regulator circuit 202 continues to operate normally (e.g. in a normal mode).

The Fbm_open_latch is set high the first time based on the rising edge of the Fbm pin lift comparator. This signal is reset on each rising edge (or failing edge) of CLK_pin_lift 218 clock to do a retry on each rising edge (or failing edge) of the Clk_pin_lift 218 clock to check if the output of the Fbm pin lift comparator (Fbm_open) is set high or low. If the pin is still open (Fbm_open="1" the S1 will be closed to use the internal ground. If the open pin disappeared (Fbm_opn="0") the switch will be open to switch to the remote sensing ground (FBM)

Also, since there is not an open-circuit (e.g. pin-lift) at the negative feedback pin (Fbm), the open-circuit (pin-lift) detector circuit 222 commands the switch (S1) to remain open and the closed-loop regulation path 216 operates normally.

Note that in various example embodiments, the clock (Clk_pin_lift) signal 218 enables the open-circuit (pin-lift) detector circuit 222 to repeatedly check (e.g. do a retry) if the pin-lift event 302 remains or disappears.

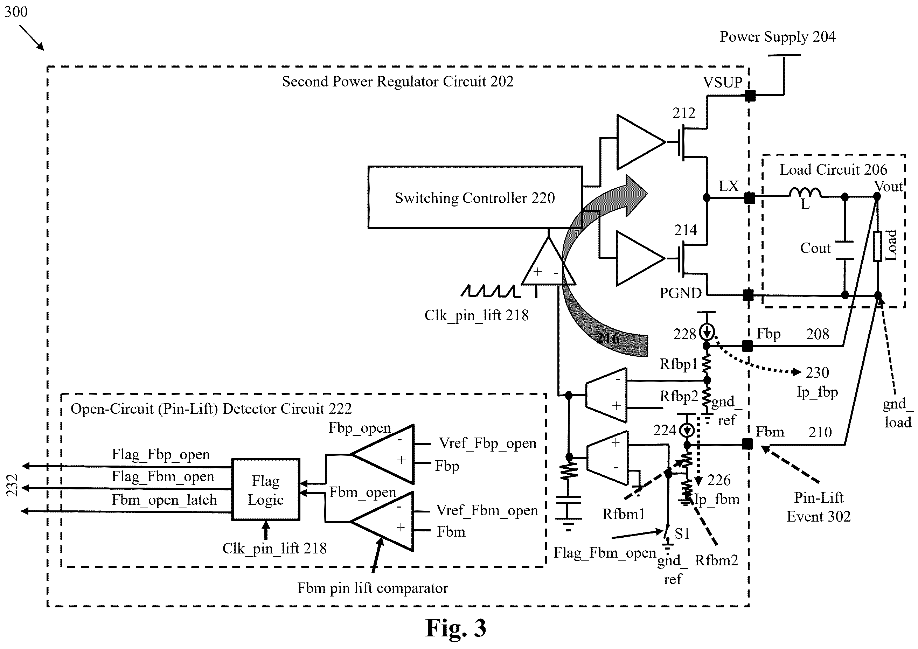

Figure 3 represents an example 300 of the second example closed-loop circuit 202 with an open-circuit (pin-lift) event 302. In contrast to example 200, in this example 300 the open-circuit (pin-lift) event 302 causes the second example closed-loop circuit 202 to enter a Fault Mode.

More specifically, with the with an open-circuit (pin-lift) event 302 at the Fbm pin, the first current (Ip_fbm) 226 instead passes through in series resistors Rfbm1 and Rfbm2.

The voltage VFbm is Ip_fbm*(Rfbm1+Rfbm2) which is greater than (i.e. exceeds) the reference voltage Vref_fbm_open and thus the Fbm_open signal is generated by the comparator as shown.

The Fbm_open signal is then latched by the flag logic and output signals Flag_Fbm_open and Fbm_open_latch are generated.

In various example embodiments, the Flag_fbm_open is routed to and closes switch (S1) which when closed shorts the Fbm to an internal reference potential (e.g. internal ground) within the second power regulator circuit 202. Note that the internal reference potential (e.g. internal ground) is different from the load ground (gnd_load).

In many other example embodiments, the Flag_fbm_open will also be sent to other circuitry in the second power regulator circuit 202, the load circuit 206, and/or other connected circuits (not shown) so as to place these circuits in a safe-mode and/or disabled or shut-down.

Thus the second power regulator circuit 202 provides a seamless transition from remote sensing the load ground (gnd_load) via the negative feedback path 110 from the low-side of load, to instead sense the internal reference potential (e.g. internal ground) within the second power regulator circuit 202.

The voltage reference is Vref - gnd_ref, the output voltage will be regulated at $Vout \left(V\right) - gnd_load \left(V\right) = V \left(Fbp, Fbm\right) = \left(Vref\left(V\right)-gnd_ref\left(V\right)\right) * \left(Rfbp1/Rfbp2+1\right) .$

Similarly, if there was an open-circuit (pin-lift) event 302 at the Fbp pin, then the second current (Ip_fbp) 230 would instead pass through in series resistors Rfbp1 and Rfbp2.

In such a case, the voltage VFbp would then be Ip_fbp*(Rfbp1+Rfbp2) which is greater than (i.e. exceeds) the reference voltage Vref_fbp_open and thus the Fbp_open signal would be generated by the comparator as shown.

Similar to as describe above, the Flag_fbp_open signal can be sent to other circuitry in the second power regulator circuit 202, the load circuit 206, and/or other connected circuits (not shown) so as to place these circuits in a safe-mode and/or disabled or shut-down.

In these example embodiments, the first and second current sources 224, 226 constantly inject fixed first and second currents respectively into the Fbm and Fbp pins to continuous monitor for any pin-lift events.

However, in other example embodiments, the open-circuit (pin-lift) detector circuit 222 may include another controller (not shown) that variably injects the first and second currents to check for any pin-lift events only at power up, at power down, under load, under no load, and/or based on other operational events.

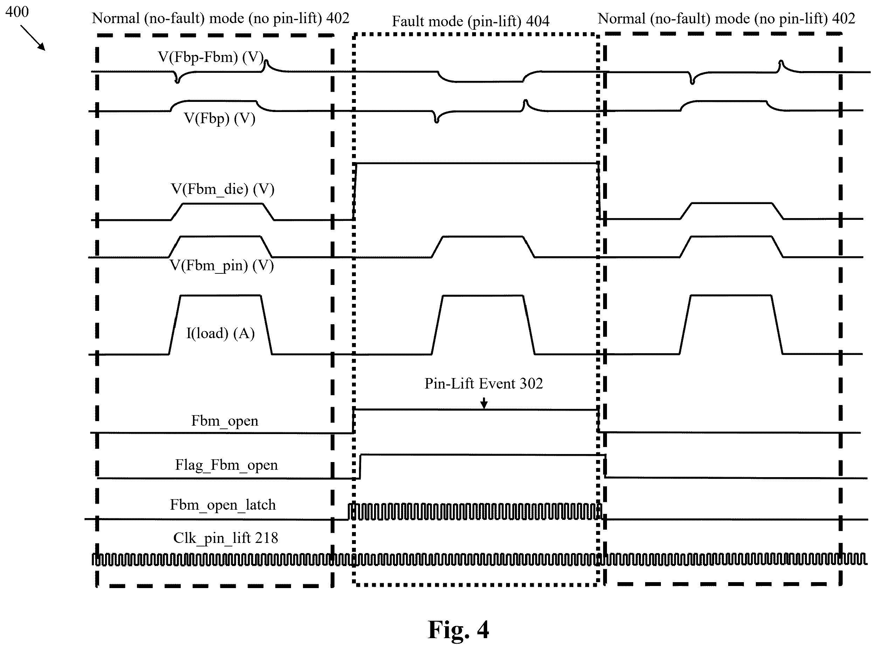

Figure 4 represents an example timing diagram 400 of the second example closed-loop circuit 202 in operation. The example 400 is shown with a normal (no-fault) mode (no pin-lift) 402 region and a fault mode (pin-lift) 404 region. Example 400 voltages are representative of when the second example closed-loop circuit 202 is a DC-DC converter.

When the Fbm_open signal is low (e.g. logic 0), then there is no open-circuit/pin-lift at the negative feedback pin (Fbm), and the second example closed-loop circuit 202 is in the normal (no-fault) mode (no pin-lift) 402 region and the remote sensing ground load pin (Fbm, "gnd_load") voltage is used for the negative feedback path 210 from the low-side of the load. The voltage across the load is constant in steady state at Fbp(V)-Fbm(V)= Vref*(Rfbp1/Rfb2+1) V.

When the Fbm_open signal is high (e.g. logic 1), then there is an open-circuit/pin-lift at the negative feedback pin (Fbm). As a result the second example closed-loop circuit 202 shifts from the normal (no-fault) mode (no pin-lift) 402 region to the fault mode (pin-lift) 404 region.

In the fault mode (pin-lift) 404 region, the switch (S1) is closed and the negative feedback path 210 instead uses the internal ground reference (gnd_ref) potential (e.g. internal ground) within the second example closed-loop circuit 202.

In the fault mode (pin-lift) 404 region, the Fbp(V) is constant in steady state Fbp(V)=Vref, Fbm(V)=0V=gnd_ref(V) , the load voltage is equal to Vout(V)-Rdrop*Iload=Vref, and thus the load is protected.

Shown also in this example 400, when the Fbm_open signal is high (e.g. logic 1), the flag logic checks (e.g. retries) on the rising edge of the clock (Clk_pin_lift) 218 to check if the pin-lift event 302 is still present.

If the pin-lift event 302 is no longer present, then the closed-loop regulation path 216 will switch back to the remote sensing ground (gnd _load) voltage, and the flag logic clears the fbm_open_flag is cleared.

In many example embodiments the functionality described above is implemented using logic gates, application specific chips, firmware, and/or other hardware. However in some example embodiments this functionality can be implemented as a set of software instructions stored in a non-transitory computer-readable or computer-usable medium.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

As used herein, "predefined" is equivalent to "predetermined" and indicates a value or setting that is tuned for a particular application/embodiment/instance of the described and/or claimed subject matter.

## Claims

1. A power regulator, comprising:
a power output node configured to be coupled to a high-side of a load;
a load ground node configured to be coupled to a low-side of the load;
a negative feedback node (Fbm) configured to form a negative feedback path when coupled to the low-side of the load;
a controller configured to regulate voltages at the power output node and the load ground node in response to a voltage on the negative feedback path;
a current source configured to inject a current at the negative feedback node (Fbm); and
a detector circuit configured to monitor a voltage (VFbm) at the negative feedback node (Fbm);
wherein the detector circuit is configured to switch the negative feedback node (Fbm) from the load ground node to an internal ground node, if the voltage (VFbm) exceeds a predetermined threshold voltage.

2. The power regulator of claim 1:
wherein the load ground node is a remote sensing external ground.

3. The power regulator of claim 1 or 2:
wherein the internal ground node is a reference potential within the power regulator that is not directly connected to the load ground node.

4. The power regulator of any preceding claim:
wherein the detector circuit is configured to disable or shut down at least one of the power regulator or the load, if the voltage (VFbm) exceeds the predetermined threshold voltage.

5. The power regulator of any preceding claim:
further comprising a switch (S1) coupled between the negative feedback node (Fbm) and the internal ground node;
wherein the detector circuit is configured to close the switch (S1) if the voltage (VFbm) exceeds the predetermined threshold voltage;

6. The power regulator of claim 5:
wherein when the switch (S1) is closed, the negative feedback node (Fbm) is directly and galvanically coupled to the internal ground node.

7. The power regulator of any preceding claim:
wherein the detector circuit is configured to switch the negative feedback node (Fbm) from the internal ground node back to the load ground node, if the voltage (VFbm) is equal to or less than the predetermined threshold voltage.

8. The power regulator of any preceding claim:
wherein the power regulator is configured to be close-loop coupled to the load.

9. The power regulator of claim 1:
wherein the detector circuit is configured to set a flag if the voltage (VFbm) exceeds the predetermined threshold voltage.

10. The power regulator of claim 9:
wherein the power regulator is configured to disable either the power regulator or the load in response to the flag.

11. The power regulator of any preceding claim:
wherein the power regulator is at least one of: a Buck converter, a pulse-width modulator circuit, a low drop out (LDO) regulator, or a linear regulator.

12. The power regulator of any preceding claim:
wherein the detector circuit is configured to repeatedly check if the voltage (VFbm) exceeds the predetermined threshold voltage.

13. The power regulator of any preceding claim:
wherein the negative feedback node (Fbm) is at least one of: an output node of a chip package in which the power regulator is embedded, or a wire bond between an integrated circuit die and a lead-frame within a chip package.

14. The power regulator of any preceding claim:
wherein the detector circuit is coupled to control the current injected by the current source at the negative feedback node (Fbm).

15. The power regulator of any preceding claim:
wherein the detector circuit is configured to cause the current source to inject the current at multiple intervals after the power regulator starts operating and before the power regulator stops operating.
